# EUROPÄISCHE PATENTSCHRIFT

(11) **EP 2 211 378 B1**
(45) Veröffentlichungstag und Bekanntmachung des Hinweises auf die Patenterteilung: **05.11.2014**
(21) Anmeldenummer: 10000793.9
(22) Anmeldetag: 27.01.2010
(51) Int. Cl.: H01L 21/677, H01L 21/00

(54) **Verfahren zur Erhöhung der Langzeitstabilität von Transporthilfsmitteln**
Method of enhancing the longivity of transport devices
Procédé d'amélioration de la longévité de dispositifs de transport

(30) Priorität: 27.01.2009 DE 102009003393
(43) Veröffentlichungstag der Anmeldung: 28.07.2010
(73) Patentinhaber: Fraunhofer Gesellschaft zur Förderung der angewandten Forschung e.V., 80686 München (DE)
(72) Erfinder: Horzel, Jörg, Dr., 63755 Alzenau (DE); Blendin, Gabriele, 63571 Gelnhausen (DE)

(56) Entgegenhaltungen:
- EP-A2- 1 032 023
- CN-A- 1 563 482
- DE-A1- 10 059 777
- JP-A- 2003 300 741

## Beschreibung

Die Erfindung bezieht sich auf ein Verfahren zur Erhöhung der mechanischen Langzeitstabilität von Transporthilfsmitteln, mittels derer zur Temperaturbehandlung Halbleiterbauelemente durch einen Prozessraum im Durchlaufverfahren gefördert werden.

Zum Bearbeiten von Halbleiterbauelementen, wie beispielsweise Silicium-Halbleiterbauelementen zur Konvertierung von Licht in elektrische Energie, ist es vorteilhaft, thermische Prozesse bei Temperaturen oberhalb von 300 °C, insbesondere bei Temperaturen zwischen 700° C und 1100° C mit Prozesssystemen durchzuführen, die einerseits einen hohen Durchsatz an Halbleiterbauelementen pro Zeiteinheit zulassen (typischerweise > 1500/h, vorteilhafterweise > 3000/h) und andererseits zu keinen Verunreinigungen, insbesondere keinen metallischen Verunreinigungen in oder auf den Halbleiterbauelementen fuhren.

Hierfür eignen sich insbesondere Durchlaufsysteme, deren Transportmechanismen auf metallische Bauteile völlig verzichten. Entsprechende thermische Prozesssysteme verzichten insgesamt auf jegliche Bauteile mit metallischen Verunreinigungen im beheizten Ofeninneren, die mit der entsprechenden Prozessatmosphäre in Berührung gelangen könnten.

Beispiele für derartige metallfreie Hochtemperatur-Durchlauföfen sind Hubbalkenöfen, Hubschnuröfen oder Öfen mit keramischen Rollen als Transportmechanismus für die Halbleiterbauelemente. Derartige Öfen werden typischerweise für Diffusionsprozesse von Halbleiterbauelementen verwendet - insbesondere von Halbleiterbauelementen aus Silicium zur Konvertierung von Licht in elektrische Energie.

Bei Diffusionsprozessen mit Diffusionsquellen unterschiedlicher Art und chemischer Zusammensetzung ist es üblich, dass sich beim Aufheizen der Halbleiterbauelemente und der darauf befindlichen Dotiermittelbeschichtung flüchtige Substanzen bilden, die sich an den Transportmechanismen bzw. Transporthilfsmitteln für die Halbleiterbauelemente abscheiden oder in diese penetrieren können. Insbesondere können dies beispielsweise bei einem Phosphordiffusionsprozess Phosphorsäure oder Polyphosphorsäuren oder Phosphorsilikatglasabscheidungen sein, die sich auf den Transporthilfsmitteln für die Halbleiterbauelemente absetzen können oder in diese eindringen, sofern diese eine Porosität aufweisen oder mit den erwähnten Substanzen wechselwirken.

Im Dauerbetrieb derartiger Durchlauföfen zur Temperaturbehandlung von Halbleiterbauelementen kann dies zur Zerstörung der Bauteile wie Keramikschnüre führen. Phosphorverbindungen, wie diese üblicherweise in Diffusionsprozessen eingesetzt werden, können z. B. durch die Hochtemperatur-Wechselwirkung die Lebensdauer der Keramikschnüre deutlich reduzieren. Ähnliches gilt für die Wechselwirkung von Phosphorverbindungen oder anderen chemischen Verbindungen, die typischerweise in Öfen zur Herstellung von Halbleiterbauelementen eingesetzt werden, wenn diese beispielsweise mit Keramikrollen oder keramischen Hubbalken in Wechselwirkung treten. So sind Systeme - wie von außen angetriebene Keramikrollen - bekannt, die durch die thermische Isolierung der Öfen hindurch in das beheizte Ofeninnere (Prozessraum) ragen. Andere Öfen verwenden keramische Balken oder zuvor genannte keramische Schnüre, um die Halbleiterbauelemente im Wesentlichen kontinuierlich mit Hub-Schreitantrieben durch das beheizte Ofeninnere zu fördern. Auch diese keramischen Transporthilfsmittel wechselwirken mit den chemischen Substanzen wie Phosphorverbindungen, wobei diese Wechselwirkung die Lebensdauer dieser Bauelemente herabsetzt.

Im Wesentlichen dringen Teile der Phosphorverbindungen in die keramischen Transporthilfsmittel wie Schnur, Balken, Stange oder Rolle ein und verringern die mechanische Stabilität bzw. Festigkeit der Bauelemente. Dies gilt insbesondere dann, wenn die Bauelemente Temperaturzyklen unterworfen werden, wie dies zum Beispiel durch Aufheizen und Abkühlen des thermischen Systems erfolgt.

Typische Prozessatmosphären in Durchlauf-Prozessanlagen zur thermischen Behandlung von Halbleiterbauelementen und insbesondere zur Diffusion von Halbleiterbauelementen zur Konvertierung von Licht in elektrische Energie enthalten neben den freigesetzten Phosphorverbindungen üblicherweise Sauerstoff, Stickstoff oder Inert- bzw. Edelgase wie Argon. Im Sinne der durchzuführenden Prozesse nach dem Stand der Technik wird darauf geachtet, dass die Atmosphäre im beheizten Ofeninneren durch die eingespeisten Prozessgase bestimmt wird, die frei von Feuchtigkeit sind.

Die DE-A-10 2006 041 424 bezieht sich auf ein Verfahren zur simultanen Dotierung und Oxidation von Halbleitersubstraten. Dabei ist vorgesehen, dass eine Oxidation in Gegenwart von Wasserdampf erfolgt, wobei die thermische Behandlung selbst gegebenenfalls in einem Durchlaufofen durchgeführt werden kann.

Gegenstand der US-A-5,527,389 ist eine Vorrichtung zur Ausbildung eines pn-Übergangs in Solarzellen. Hierzu werden die Wafer durch mehrere Prozessräume geführt, in denen eine gewünschte Luftfeuchtigkeit herrscht. Der Transport erfolgt über aus Papier oder Stoff bestehende Transportbänder bei Temperaturen < 50 °C im Durchlaufverfahren.

Die GB-A-1 314 041 sieht zum Prozessieren von Halbleitermaterial Prozessräume vor, in denen eine feuchte Atmosphäre herrscht.

Aus der DE-B-103 25 602 sind ein Hubschnur- oder Hubbalkentransport oder keramische Ketten bekannt, um Substrate in einer temperaturgeregelten Prozessierung kontinuierlich oder getaktet durch eine Reaktionskammer zu transportieren.

Keramikschnüre zum Transport von zu prozessierenden Elementen durch eine Hochtemperaturzone werden in der DE-B-100 59 777 beschrieben.

Eine Oxidationsvorrichtung ist aus der US-A-2005/0208737 bekannt. Dabei wird Prozessgas durch Einleiten einer Flüssigkeit befeuchtet.

Ein Verfahren zum Herstellen einer dielektrischen Schicht wird in der US-B-6,281,141 beschrieben.

Der EP-A-1 032 023 sind ein Verfahren und eine Anordnung zum kontinuierlichen Behandeln von Gegenständen zu entnehmen. Die zu transportierenden Gegenstände werden dabei auf Werkstückträgern gelagert, die zwischen Rahmen gespannte Drähte umfassen.

Die JP-A-2003300741 bezieht sich auf einen Heizofen zum Versiegeln von Flachbildschirmen.

Mittels eines Transportbandes oder -rollen werden nach der CN-A-200410026828 Gegenstände durch einen Prozessraum gefördert.

Der vorliegenden Erfindung liegt die Aufgabe zugrunde, ein Verfahren der eingangs genannten Art so weiterzubilden, dass die zum Transport der Halbleiterbauelemente verwendeten Transporthilfsmittel im Vergleich zu bekannten Verfahren eine deutlich bessere mechanische Langzeitstabilität zeigen. Ferner soll das Eindringen von metallischen Verunreinigungen in die Halbleiterbauelemente verhindert werden.

Zur Lösung der Aufgabe sieht die Erfindung im Wesentlichen vor, dass als Transporthilfsmittel aus keramischen Materialien bestehende Materialien verwendet werden, die in dem zur Außenatmosphäre hin geöffneten Prozessraum gezielt einer Wasserdampf enthaltenden feuchten Atmosphäre ausgesetzt werden, wobei in dem Prozessraum die Temperaturbehandlung bei einer Temperatur T mit T ≥ 500° C durchgeführt wird.

Abweichend vom Stand der Technik wird aufgrund der erfindungsgemäßen Lehre eine feuchte Atmosphäre gezielt zumindest in Teilbereichen des Prozessraums erzeugt bzw. eingestellt, in dem die aus keramischem Material bzw. keramischen Materialien bestehenden Transportmittel vorhanden sind bzw. verlaufen.

Es wird im Inneren der grundsätzlich zur Außenatmosphäre hin geöffneten Durchlaufprozessanlage zur Temperaturbehandlung, insbesondere Hochtemperaturbehandlung von Halbleiterbauelementen, die insbesondere zur Konvertierung von Licht in elektrische Energie verwendet werden sollen, gezielt eine feuchte Atmosphäre erzeugt.

Beispielsweise kann durch Pyrolyse Feuchte in den beheizten Prozessraum eingespeist werden. Es besteht jedoch auch die Möglichkeit, über z. B. einen sogenannten "Bubbler" Prozessgase wie Sauerstoff oder Stickstoff oder trockene Druckluft durch ein mit Flüssigkeit wie Wasser gefülltes, vorzugsweise beheiztes Gefäß zu leiten, um sodann in das Ofeninnere, also den Prozessraum, eingespeist zu werden. Während des Durchperlens durch die Flüssigkeit nehmen die entsprechenden Gase Feuchtigkeit auf. Es besteht jedoch auch die Möglichkeit, unmittelbar Wasserdampf in den Prozessraum einzuleiten.

Überraschenderweise hat sich gezeigt, dass gezielt in den Prozessraum eingespeiste Feuchtigkeit als Schutz für die den Transport ermöglichenden keramischen Transporthilfsmittel oder Elemente wirkt.

Es schlägt sich Wasserdampf an den Bereichen der keramischen Transporthilfsmittel als Kondensat nieder, die sich bei Temperaturen unterhalb von 100 °C im Aufheiz- und Abkühlbereich der thermischen Anlage, insbesondere des Prozessraums befinden. Soll z.B. in den Halbleiterbauelementen ein Phosphordiffusionsprofil zur Ausbildung eines pn-Übergangs in einem p-leitenden Halbleitersubstrat ausgebildet werden, werden Phosphorverbindungen daran gehindert, sich an den Transporthilfsmitteln anzureichern bzw. in höherer Konzentration in die Keramikbauteile zu penetrieren. Das Abspalten von Wasser aus den mit den Halbleiterbauelementen in Kontakt befindlichen Phosphorverbindungen wie beispielsweise Phosphorsäure oder Phosphor-Sol-Gel-Dotierstoffquellen, das üblicherweise mit steigender Prozesstemperatur zunimmt, wird durch die Anwesenheit von Wasserdampf in der Prozessraumatmosphäre, also im Prozessraum verzögert, so dass sich die Diffusionsquelle in anderer Form umwandelt, als dies bei herkömmlichen Prozessen zur Prozessierung von Halbleiterbauelementen der Fall ist.

Dies gilt insbesondere bei der Diffusion von Halbleiterbauelementen zur Konvertierung von Licht in elektrische Energie, die aus Wirtschaftlichkeitsgründen typischerweise Phosphorquellen, wie Phosphorpasten, Sol-Gel-Phosphorquellen und/oder wässrige Phosphorsäure-Lösung verwenden, die jeweils organische Bestandteile wie Lösungsmittel und Benetzungsmittel beinhalten können.

Ungeachtet der veränderten Form der Umwandlung der Diffusionsquelle wird bei angepasster Prozessführung (Prozesstemperatur/-zeit/restliche Prozessgaszusammensetzung) keine Beeinträchtigung der durch die Prozessierung zu erzielenden Eigenschaften des Halbleiterbauelements bewirkt.

Auch bei höheren Prozesstemperaturen im Prozessraum, also im Inneren von Temperaturbehandlungsöfen, kommt es zu einer Wechselwirkung zwischen der in das Ofeninnere, also in den Prozessraum, eingeleiteten Feuchte mit den keramischen Transporthilfsmitteln zum Transport der Halbleiterbauelemente sowie zu einer Wechselwirkung mit den Halbleiterbauelementen selbst. Dabei hält die eingeleitete Feuchte die keramischen Bauelemente wie Keramikschnüre, Keramikrollen und/oder Keramikstangen, die sich üblicherweise aus Al₂O₃, SiO₂, SiC und anderen für Halbleiterprozesse hochreinen keramischen Stoffen zusammensetzen, in einem Zustand, in dem sich keine Phosphorverbindungen in deren Oberflächen festsetzen oder in schädlicher Form in diese eindringen können.

Ein weiterer auftretender Effekt ist folgender. So führt eine erhöhte Feuchte im beheizten Ofeninneren dazu, dass Oxidationsprozesse schneller ablaufen. Somit werden metallische Verunreinigungen, sofern diese in Kleinstmengen im Prozessraum vorhanden sind, sofort oxidiert und damit für die Halbleiterbauelemente unschädlich gemacht, während andernfalls Phosphorverbindungen diese metallischen Verunreinigungen aus der keramischen Oberfläche herauslösen. Das schnelle Oxidieren aller Oberflächen wirkt als Schutz und erhöht insbesondere die Lebensdauer der keramischen Transporthilfsmittel erheblich.

Untersuchungen haben ergeben, dass grundsätzlich alle keramischen Bauelemente in feuchter Atmosphäre bei Hochtemperaturverfahren auch ohne die Anwesenheit von Phosphorverbindungen oder anderen chemischen Verbindungen in der Prozessatmosphäre eine deutlich bessere mechanische Langzeitstabilität aufweisen. Dies gilt insbesondere auch dann, wenn durch die Feuchte im Ofeninneren, also im Prozessraum, reduzierende Prozessatmosphären vermieden werden können.

Aber auch die Oxidation der Halbleiterbauelement-Oberflächen, wie beispielsweise bei der Diffusion von Phosphor (P) aus zuvor aufgebrachten P-Diffusionssquellen in Silicium-Halbleiterbauelemente zur Konvertierung von Licht in elektrische Energie, bietet erhebliche Prozessvorteile bei der Herstellung dieser Halbleiterbauelemente:
- Die schneller verlaufende Oxidation von Silicium bei feuchter Atmosphäre und erhöhter Prozesstemperatur führt zu einem in situ Schutz von nicht mit der Phosphorquelle versehenen Oberflächenbereichen des Halbleiterbauelementes, da die sich ausbildende vergleichsweise dicke Siliciumoxidschicht Verunreinigungen von außen davon abhält, ins Halbleitermaterial einzudringen. Diese Oxidschutzschicht, die parallel auch Verunreinigungen aus dem Inneren der Halbleiterbauelemente aufnehmen kann, kann nach Abschluss des Temperaturbehandlungsschrittes wahlweise als Passivierschicht für die Halbleiterbauelement-Oberfläche weiter verwendet werden - wie die Rückseiten-Passivierung von Halbleiterbauelementen zur Konvertierung von Licht in elektrische Energie - oder teilweise oder vollständig entfernt werden. Hierzu kommen beispielsweise Laser-Ablationsverfahren und/oder Ätzverfahren wie z. B. verdünnte Flusssäure oder Flusssäure-Dampf in Frage.
- Die Oxidation der Halbleiterbauelementoberflächen schreitet im Vergleich zu trockenen Prozessatmosphären bei feuchter Atmosphäre deutlich schneller voran. So treten bereits bei Temperaturen unterhalb von 700 °C nennenswerte Oxidationsraten ein, die somit deutlich früher als bei typischen Durchlaufprozessen zur Temperaturbehandlung von Halbleiterbauelementen zu einer Schutzwirkung durch die Halbleiter-Oxid-Schutzschicht führen. Bei typischen Diffusionsprozessen für Silicium ist dies andernfalls erst ab 750 °C nennenswert der Fall.

Die Oxidationsrate erhöht sich auch an der Grenzfläche zwischen der zuvor aufgebrachten Dotierstoffquelle und dem Halbleiterbauelement, auf das erstere selektiv oder ganzflächig aufgebracht wurde. Durch Steuern der Feuchtigkeit in der Prozessatmosphäre und dem zugehörigen Temperatur-Zeitverlauf bei einem Diffusionsprozess lässt sich damit im Gegensatz zum Stand der Technik die Phosphoreindiffusionsrate sehr erheblich beeinflussen. Während beispielsweise bei Verwendung einer Phosphorsäurelösung als Dotierstoffquelle die Dotierstoff-Oberflächenkonzentration im Halbleiterbauelement im Wesentlichen nur durch die Prozesstemperatur beeinflusst werden kann, ist es aufgrund des erfindungsgemäßen Verfahrens und den zugehörigen Prozessanlagen möglich, über die Oxidationsrate an der Grenzfläche Halbleitermaterial (bevorzugt Silicium) zur Dotierstoffquelle erheblichen Einfluss darauf zu nehmen, wieviel Dotierstoff in den Halbleiter eindringen kann. Damit lässt sich die Dotierstoffkonzentration bei gleichem Temperatur-Zeitprofil um mehrere Größenordnungen beeinflussen, wenn der Temperatur-Zeit-Verlauf und die Feuchtigkeitseinspeisung entsprechend geeignet gewählt werden.

Dabei konnte unabhängig von der Art der Feuchtigkeitseinspeisung eine ausreichende Schutzwirkung für die keramischen Transporthilfsmittel festgestellt werden.
- Durch die höheren Oxidationsraten an der Grenzfläche zwischen Dotierstoffquelle und Halbleitermaterial wie vorzugsweise Silicium entsteht eine vergleichsweise dicke SiOx-Grenzschicht (Halbleiteroxid), die während dem Hochtemperaturbehandlungsschritt im Halbleitermaterial neu wächst. Diese Schicht lässt sich in nachfolgenden Prozessschritten zum Entfernen der Dotierstoffquelle nach der Diffusion leichter und rückstandsfreier entfernen als dies üblicherweise der Fall ist, wenn beispielsweise Sol-Gel-Phosphor-Diffusionsquellen verwendet werden, bei denen organische Rückstände als pyrolytischer Kohlenstoff ins Halbleitermaterial eingelagert werden kann, oder bei Diffusionsquellen mit sehr hoher P-Konzentration wie beispielsweise Phosphorsäurelösungen, bei denen Phosphor in der Halbleiteroberfläche auch elementar auf Zwischengitterplätzen eingelagert werden kann. Typische Nachbehandlungsverfahren wie das Behandeln der Oberflächen in Flusssäure reichen häufig nicht, um alle unerwünschten Verunreinigungen in der Siliciumoberfläche zu entfernen.
   Durch die Oxidation in feuchter Atmosphäre werden derartige Verunreinigungen bereits von vornherein reduziert oder vermieden.
- Insbesondere kann die Oxidation der Halbleiterbauelemente wahlweise so gesteuert werden, dass erst gegen Ende des Transportwegs im Prozessraum, also des Diffusionsofens eine erhöhte Feuchtigkeit eingestellt wird und es somit zu einer erhöhten Oxidationsrate kommt. Dies ist dadurch möglich, dass durch unterschiedliche Druckverhältnisse im Ofen und geeignete Positionierung von Prozessgas-Einspeisepunkten und Prozessgasabsaugungen bzw. geeignete Querschnittsreduzierungen des für den Durchlauf der Halbleitersubstrate offenen Raumes eine effektive Atmosphärentrennung bewirkt wird. So kann beispielsweise in einer vorteilhaften Anwendung des Verfahrens dann nur im hinteren Teil eines Durchlaufdiffusionsofens die Grenzschicht zwischen Diffusionsquelle und der darunterliegenden Halbleiterbauelement-Oberfläche mit erhöhter Oxidationsrate oxidiert werden und dort die Dotierstoffquelle verarmt bzw. bereits ins Silicium eingetriebene Dotierstoffbereiche umgewandelt werden, so dass diese in nachfolgenden Prozessschritten (z.B. Flusssäurebehandlung) entfernt werden können. Dies lässt die Kombination aus hohen Diffusionsraten und Diffusionsgeschwindigkeiten zu Beginn des Diffusionsprozesses mit einer gezielten Reduzierung der P-Oberflächenkonzentration sowie dem gezielten Entfernen von in den hoch dotierten Bereichen angesammelten und dann anschließend in Oxidschichten eingelagerten Verunreinigungen zu. Die Feuchtigkeitssteuerung bzw. -regelung in zuvor erläutertem Verfahren gilt ganz allgemein, also kann auch dann durchgeführt werden, wenn kein Diffusionsprozess erfolgt.

Vorzugsweise wird die feuchte Prozessatmosphäre mit Hilfe eines als Trägergas zu bezeichnenden Prozessgases wie O₂, N₂, Druckluft, Ar in das beheizte Ofeninnere des Durchlaufofens, also den Prozessraum zur Temperaturbehandlung eingeleitet.

Dafür eignen sich beispielsweise keramische Bauteile bzw. Quarzbauteile, die das Prozessgas möglichst gleichmäßig über die Breite des Durchlaufsystems hinweg an geeigneter Stelle in den Ofen einleiten. Insbesondere eigenen sich für die gleichmäßige Verteilung der Prozessgase auch poröse keramische Platten oder Rohre. Bei dieser Form der Gaseinspeisung kann Prozessgas mit nahezu derselben Temperatur in den Ofen eingeleitet werden, wie dessen Innentemperatur an der entsprechenden Stelle ist.

Vorteilhafterweise kann die feuchte Prozessatmosphäre an mehreren Stellen entlang des beheizten Durchlaufofens zur Temperaturbehandlung von Halbleiterbauelementen wie beispielsweise der P-Diffusion von Silicium eingespeist werden. Vorzugsweise befinden sich dabei zwischen einzelnen Bereichen des thermischen Systems entlang der Transportrichtung der Halbleiterbauelemente auch an geeigneten Stellen Prozessgas-Absaugungen, die ebenfalls gleichmäßig über die Breite des Ofens hinweg gleichmäßig gezielt Prozessatmosphäre in gewünschtem Volumenstrom dem Ofen entziehen.

Ferner kann es vorteilhaft sein, zwischen einzelnen von der Prozessatmosphäre her unterschiedlichen Bereichen Querschnittsreduzierungen vorzunehmen, die den Austausch der Gasatmosphären zwischen den jeweiligen Bereichen einschränken oder minimieren. Es ist lediglich sicherzustellen, dass die Halbleiterbauelemente durch diese verengten Querschnitte problemlos weiter transportiert werden können.

Typische Prozessbedingungen für die angestrebten Prozesse sehen vor, dass die Halbleiterbauelemente auf Prozesstemperaturen von 500 °C bis 1150 °C, vorzugsweise im Bereich von 800 °C bis 1100 °C erwärmt werden.

Bei Herstellung von Halbleiterbauelementen zur Konvertierung von Licht in elektrische Energie ist es dabei vorteilhaft, die maximale Prozesstemperatur auf 920 °C zu beschränken.

Bei Prozessen zur Diffusion von Phosphor (P) verwendet man in derartigen kostengünstigen Herstellungsverfahren wie Durchlaufverfahren Dotierstoffquellen, die flüchtige Bestandteile enthalten, die bei der Temperaturbehandlung entweichen.

Daher ist es oft vorteilhaft, sauerstoffhaltige Prozessgas-Atmosphären zu verwenden. Sauerstoffarme Prozessgasatmosphären können beim Entfernen der flüchtigen Bestandteile der Dotierstoffquellen wie Phosphorsäurelösungen (teilweise mit organischen Zusätzen) oder Sol-Gel-P-Dotierstoffquellen oder P-Pasten dazu führen, dass reduzierende Atmosphären entstehen, die die keramischen Bauteile des Durchlaufofens angreifen, bzw. den Halbleiter-Diffusionsprozess durch verbleibende Rückstände stören. Es gilt daher derartige reduzierende Bedingungen in der Ofenatmosphäre zu vermeiden; auch hierbei hilft das Einleiten von feuchtem Prozessgas.

Typische Prozesszeiten bei den Temperaturbehandlungsverfahren zur Herstellung von Halbleiterbauelementen zur Konvertierung von Licht in elektrische Energie liegen bei 2 min. bis 60 min. inklusive der Aufheiz- und Abkühlrampen für diese Prozesse.

Die Methoden zur Herstellung von feuchten Gasatmosphären sind mit denen vergleichbar, die für geschlossene thermische Temperaturbehandlungssysteme wie zum Beispiel zur thermischen Nassoxidation in geschlossenen Quarzrohr-Öfen bereits in der Halbleiterindustrie eingesetzt werden.

Vorteilhaft ist es, am Einlaufbereich und/oder Auslaufbereich der Öfen für nahezu kontinuierliche Durchlaufprozesse in offenen Systemen sogenannte Schleusenbereiche zu haben, die für eine gastechnische Entkopplung der Prozessatmosphäre im Ofeninneren von den Bereichen unkontrollierter Atmosphäre außerhalb der Öfen sorgen.

Eine vorteilhafte Anwendung der Erfindung sieht vor, einen Diffusionsprozess zum Eintreiben von Phosphor aus einer zuvor aufgebrachten Phosphordotierstoffquelle in einem Durchlaufverfahren in einem sogenannten Hubschnurofen durchzuführen. Durch das geeignete Einspeisen von feuchter Prozessatmosphäre in das beheizte Ofeninnere (Prozessraum) wird dabei die Lebensdauer der vergleichsweise teuren Keramikschnüre und deren Beständigkeit gegen Phosphorverbindungen deutlich erhöht, so dass die laufenden Prozesskosten gesenkt werden können.

Gleichzeitig ist es möglich, mit derartigen Öfen und Verfahren Halbleiterbauelemente herzustellen, die vorteilhaft gegenüber dem Stand der Technik sind, da sich die Dotierstoffkonzentration im Dotierstoffprofil durch die in feuchter Atmosphäre durchgeführte Oxidation besser einstellen und auch verringern lässt, sowie das Halbleiterbauelement gezielt vor Verunreinigungsatomen geschützt bzw. von diesen gereinigt werden kann. Folglich sind höhere Wirkungsgrade beim Konvertieren der Halbleiterbauelemente von Licht in elektrische Energie möglich.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines bevorzugten Ausführungsbeispiels.

Es zeigen:
- Fig. 1: eine Prinzipdarstellung eines Durchlaufofens zur Durchführung des erfindungsgemäßen Verfahrens und
- Fig. 2: einen Längsschnitt durch den Durchlaufofen gemäß Fig. 1, jedoch ohne Trans- portmittel.

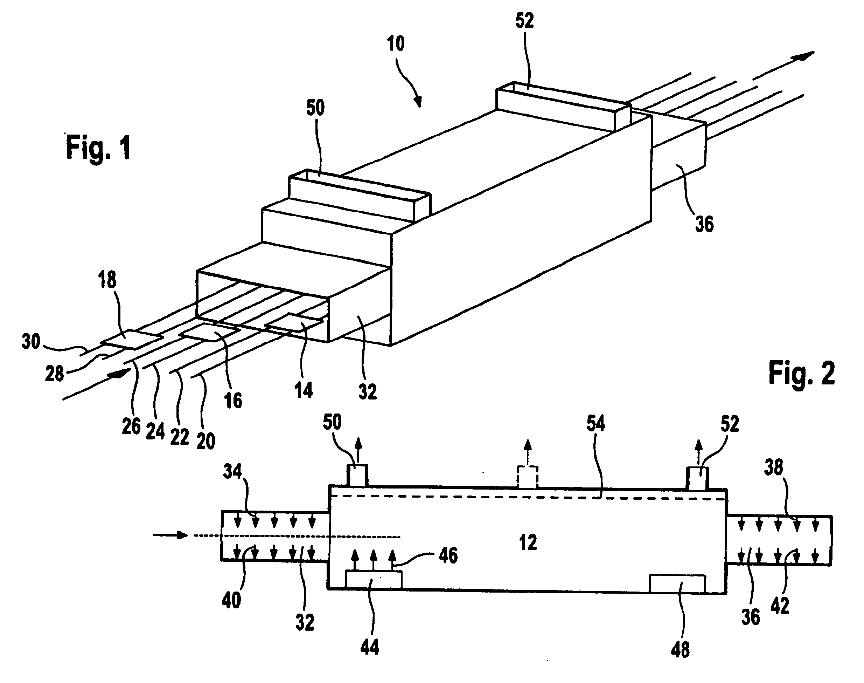

Um Halbleiterbauelemente zu prozessieren, ohne dass Verunreinigungen in die Halbleiterbauelemente eindringen, wird erfindungsgemäß ein Durchlaufofen 10 benutzt, der rein prinzipiell den Fig. 1 und 2 zu entnehmen ist. Der Durchlaufofen 10 weist einen Prozessraum 12 auf, in dem im Ausführungsbeispiel Wafer 14, 16, 18 als Halbleiterbauelement hindurchgeführt und einer Temperaturbehandlung bei einer Temperatur T mit T ≥ 500 °C unterzogen werden. Bei der Temperaturbehandlung werden z. B. Diffusionsprozesse durchgeführt, um z.B. Phosphor aus einer zuvor auf die Wafer 14, 16, 18 aufgebrachte Phosphordotierstoffquelle einzutreiben.

Damit metallische Verunreinigungen in die Wafer 14, 16, 18 während der Temperaturbehandlung nicht eindringen können, werden Transporthilfsmittel aus keramischen Materialien benutzt. Bei den Transporthilfsmitteln kann es sich um z.B. Keramikschnüre 20, 22; 24, 26; 28, 30 eines Hubschnurtransportsystems handeln. Als Keramiken kommen z. B. Al₂O₃, SiO₂, SiC oder andere für Halbleiterprozesse bekannte hochreine keramische Stoffe in Frage. Dabei ist die Wahl der Keramiken derart zu treffen, dass sich Phosphor- oder Borverbindungen in deren Oberflächen nicht festsetzen können.

Wie sich aus den Fig. 1 und 2 ergibt, ist dem eigentlichen Durchlaufofen 10, also dem Prozessraum 12, eine Schleuse 32 vorgeschaltet, in die Druckluft oder N₂ oder O₂ oder Argon als Prozessgas eingleitet wird (siehe Pfeile 34). Dabei sollte das Prozessgas einen Überdruck in der Schleuse 32 erzeugen, so dass die Atmosphäre im Prozessraum 12 durch eindringende Außenluft nicht unerwünscht beeinflusst wird.

Im Ausführungsbeispiel ist dem Prozessraum 12 eine weitere Schleuse 36 nachgeordnet, in der ebenfalls ein entsprechendes Prozessgas eingeführt wird (Pfeile 36), das gegenüber dem Prozessraum 12 einen Überdruck erzeugt.

Die Prozessgase werden in den Schleusen 32, 36 abgesaugt. Dies wird durch die Pfeile 40, 42 symbolisiert.

Die Schleusen 32, 36 werden in Bezug auf ihre Atmosphäre derart eingestellt, dass im Prozessraum 12 und in den Schleusen 32, 36 kein Kondensat auf die Wafer 14, 16, 18 gelangt, das aus der Atmosphäre im Prozessraum 12 ausfällt oder sich an Bauteilen des Ofens 10 oberhalb der Wafer 14, 16, 18 absetzt und auf die Wafer 14, 16, 18 tropfen könnte. Die Schleuse 32 bzw. 36 bewirkt im Wesentlichen eine gezielte Gasströmung zum Einstellen gewünschter Atmosphären, gegebenenfalls unterschiedlicher Atmosphären im Prozessraum 12 (Feuchtigkeit).

Um gezielt Feuchtigkeit in den Prozessraum 12 einzubringen, die sich auf die Transporthilfsmittel - also im Ausführungsbeispiel auf die Keramikschnüre 20, 22, 26, 28, 30 und die in dem Durchlaufofen 10 vorhandenen Führungen - positiv in Bezug auf deren Dauerbeständigkeit auswirkt, sind im Eingangsbereich, und zwar im Ausführungsbeispiel im Bodenbereich, des Prozessraums 12 unterhalb des Transportwegs Einspeisungen 44 für die eine gewünschte Feuchtigkeit aufweisenden Prozessgase vorhanden, die in den Prozessraum 12 strömen (Pfeile 46). Insbesondere enthalten die Prozessgase Wasserdampf, wobei die Temperatur oberhalb von 100 °C liegen sollte. Die Einspeisung kann auch von der Seite oder insbesondere von oben erfolgen.

Entsprechend der Darstellung in Fig. 2 ist auch im Bereich des Prozessraumausgangs eine entsprechende Einspeisung 48 vorgesehen. Dies ist jedoch nicht zwingend.

Prozessgas kann sodann z.B. im Kopfbereich des Prozessraums 12 abgesaugt werden. Beispielhaft sind Öffnungen mit den Bezugszeichen 50, 52 gekennzeichnet.

Ferner befindet sich im Kopfbereich des Prozessraums 12 eine Heizeinrichtung 54, die z.B. aus Widerstandsheizelementen oder aus Lampen bestehen kann. Gegebenenfalls ist auch unterhalb der Transportebene, entlang der die Wafer 14, 16, 18 transportiert werden, eine entsprechende Heizeinrichtung vorgesehen, um in dem Prozessraum 12 die gewünschte Temperatur T mit T ≥ 500 °C einzustellen.

Durch die feuchte Prozessatmosphäre im Prozessraum 12 wird nicht nur verhindert, dass Verunreinigungen in die Wafer 14, 16, 18 eindringen, sondern gleichzeitig wird die Lebensdauer der Keramikschnüre 20, 22, 24, 26, 28, 30 erhöht, insbesondere auch deren Beständigkeit gegen Phosphorverbindungen, sofern Phosphordotierstoffquellen vorgesehen sind. Gleichzeitig ergibt sich der Vorteil, dass sich die Dotierstoffkonzentration im Dotierstoffprofil der Wafer 14, 16, 18 durch die in der feuchten Atmosphäre durchgeführte Oxidation besser einstellen und auch verringern lässt. Somit ergeben sich Halbleiterbauelemente mit einem hohen Wirkungsgrad, wenn Licht in elektrische Energie konvertiert werden soll.

## Patentansprüche

1. Verfahren zur Erhöhung der mechanischen Langzeitstabilität von Transporthilfsmitteln (20, 22, 24, 26, 28, 30), mittels derer zur Temperaturbehandlung Halbleiterbauelemente (14, 16, 18) durch einen Prozessraum (12) im Durchlaufverfahren gefördert werden,
**dadurch gekennzeichnet,**
**dass** als Transporthilfsmittel (20, 22, 24, 26, 28, 30) aus keramischen Materialien bestehende Materialien verwendet werden, die in dem zur Außenatmosphäre hin geöffneten Prozessraum (12) gezielt einer Wasserdampf enthaltenden feuchten Atmosphäre ausgesetzt werden, wobei in dem Prozessraum (12) die Temperaturbehandlung bei einer Temperatur T mit T ≥ 500° C durchgeführt wird.

2. Verfahren nach Anspruch 1,
**dadurch gekennzeichnet,**
**dass** die Halbleiterbauelemente (14, 16, 18) mittels eines keramischen Hubschnurtransportsystems oder eines keramischen Hubbalkentransportsystems oder mittels keramischer Transportrollen durch einen Durchlaufofen (10) gefördert werden, wobei vorzugsweise die Transportrollen außerhalb des Durchlaufofens (10) angetrieben werden.

3. Verfahren nach Anspruch 1 oder 2,
**dadurch gekennzeichnet,**
**dass** zur Einstellung der feuchten Atmosphäre Feuchtigkeit oder Feuchtigkeit enthaltende Prozessgase in den Prozessraum (12) eingespeist werden, wobei insbesondere die Feuchtigkeit in dem Prozessraum (12) gesteuert oder geregelt wird.

4. Verfahren nach zumindest einem der vorherigen Ansprüche,
**dadurch gekennzeichnet,**
**dass** die Feuchtigkeit mittels eines Prozessgases wie O₂, N₂, Druckluft und/oder Edelgas wie Argon in den Prozessraum (12) oder in den Prozessraum (12) feuchte Prozessgasatmosphäre oder die Feuchtigkeit durch Pyrolyse in den Prozessraum eingeleitet wird, wobei insbesondere das die Feuchtigkeit transportierende Prozessgas mit einer Temperatur Tₚ mit Tₚ ≥ 100 °C in den Prozessraum (12) eingeleitet wird, die bevorzugt der oder in etwa der im Einleitbereich im Prozessraum entspricht.

5. Verfahren nach zumindest einem der vorherigen Ansprüche,
**dadurch gekennzeichnet,**
**dass** vor der Förderung des Halbleiterbauelementes durch den Prozessraum auf dessen Oberfläche eine Dotierstoffquelle aufgebracht wird, wobei insbesondere als Dotierstoffquelle eine solche verwendet wird, die Phosphor oder Bor enthält.

6. Verfahren nach zumindest einem der vorherigen Ansprüche,
**dadurch gekennzeichnet,**
**dass** ein oder mehrere Prozessgase durch eine Flüssigkeit wie Wasser zur Aufnahme von Feuchtigkeit geleitet und sodann dem Prozessraum (12) zugeführt wird bzw. werden.

7. Verfahren nach zumindest einem der vorherigen Ansprüche,
**dadurch gekennzeichnet,**
**dass** die Halbleiterbauelemente (14, 16, 18) wie Silicium-Halbleiterbauelemente, die zur Konvertierung von Licht in elektrische Energie verwendet werden, durch den Prozessraum (12) gefördert werden, der einlass- und/oder auslassseitig zur Atmosphäre offen ist, wobei die Atmosphäre in dem Prozessraum (12) derart eingestellt und/oder das die Feuchtigkeit aufweisende Prozessgas derart eingeleitet werden, dass ein Kondensatniederschlag auf dem Halbleiterbauelement (14, 16, 18) vermieden wird.

8. Verfahren nach zumindest einem der vorherigen Ansprüche,
**dadurch gekennzeichnet,**
**dass** dem Prozessraum (12) zumindest einlassseitig Feuchtigkeit gezielt zugeführt wird und/oder dass zur gezielten Einstellung der Feuchtigkeit in Bereichen des Prozessraums (12) gewünschte Druckverhältnisse in dem Prozessraum (12) eingestellt werden und/oder dass der Prozessraum (12) zur Einstellung der Feuchtigkeit mehrere Prozessgaseinspeise- und/oder -absaugpunkte (44, 48, 50, 52) aufweist und/oder dass Feuchtigkeit enthaltendes Prozessgas in auslassseitigem Endbereich bzw. auslassseitiger Hälfte des Prozessraums diesem zugeführt wird.

9. Verfahren nach zumindest einem der vorherigen Ansprüche,
**dadurch gekennzeichnet,**
**dass** zur Einstellung der Feuchtigkeit ein Prozessraum (12) verwendet wird, dessen Querschnitt in Förderrichtung der Halbleiterbauelemente (14, 16, 18) variiert, und/oder dass Feuchtigkeit in den Prozessraum (12) einleitendes Prozessgas über quer zur Transportrichtung der Halbleiterbauelemente (14, 16, 18) sich erstreckende Breite des Prozessraums diesem zugeführt und/oder abgesaugt wird, wobei gegebenenfalls das Prozessgas gleichmäßig über die Breite verteilt dem Prozessraum (12) zugeführt und/oder gleichmäßig über die Breite des Prozessraums (12) verteilt Prozessgas abgesaugt wird.

10. Verfahren nach zumindest einem der vorherigen Ansprüche,
**dadurch gekennzeichnet,**
**dass** sauerstoffhaltiges Prozessgas dem Prozessraum (12) zugeführt wird.

11. Verfahren nach zumindest einem der vorherigen Ansprüche,
**dadurch gekennzeichnet,**
**dass** Einlauf- und/oder Auslaufbereich des Prozessraums (12) ein Schleusenbereich vor- bzw. nachgeordnet wird.

12. Verfahren nach zumindest einem der vorherigen Ansprüche,
**dadurch gekennzeichnet,**
**dass** der Prozessraum (12) bzw. dessen Atmosphäre gegenüber der Atmosphäre außerhalb des Prozessraums (12) strömungstechnisch entkoppelt wird.

13. Verfahren nach zumindest einem der vorherigen Ansprüche,
**dadurch gekennzeichnet,**
**dass** Prozessgas über poröse Keramikplatten und/oder -rohre in den Prozessraum (12) eingeleitet wird.

14. Verfahren nach zumindest einem der vorherigen Ansprüche,
**dadurch gekennzeichnet,**
**dass** die Temperaturbehandlung der Halbleiterbauelemente (14, 16, 18) bei der Temperatur T mit 800 °C ≤ T ≤ 1100 °C durchgeführt wird, wobei insbesondere während der Temperaturbehandlung flüchtige Bestandteile, insbesondere Phosphorverbindungen als flüchtige Bestandteile aus den Halbleiterbauelementen (14, 16, 18) ausgetrieben werden.

15. Verfahren nach zumindest einem der vorherigen Ansprüche,
**dadurch gekennzeichnet,**
**dass** während der Temperaturbehandlung in den Halbleiterbauelementen (14, 16, 18) ein Diffusionsprofil, insbesondere ein Phosphor-Diffusionsprofil, hergestellt wird.

## Claims

1. Procedure for increasing the mechanical long-term stability of transport aids (20, 22, 24, 26, 28, 30), by means of which semiconductor elements (14, 16, 18) are fed for heat treatment through a process chamber (12) in continuous-flow process,
**characterized in**
**that** materials made of ceramic materials are used as a transport aids (20, 22, 24, 26, 28, 30), which are exposed specifically to a humid atmosphere in the process chamber (12) open to the outside atmosphere, whereby heat treatment in the process chamber (12) is performed at a temperature T ≥ 500°C.

2. Procedure according to claim 1,
**characterized in**
**that** the semiconductor elements (14, 16, 18) are fed by means of a ceramic walking-filament transport system or a ceramic lifting bar transport system or by means of ceramic transport rollers through the continuous-flow furnace (10), whereby preferably the transport rollers are driven outside the continuous-flow furnace (10).

3. Procedure according to claim 1 or 2,
**characterized in**
**that** humidity or humidity containing process gases are fed into the process chamber (12) to adjust the humid atmosphere, whereby especially the humidity is controlled or regulated in the process chamber (12).

4. Procedure according to at least one of the preceding claims,
**characterized in**
**that** the humidity is introduced into the process chamber (12) by means of a process gas such as O₂, N₂, compressed air, and/or noble gas such as argon, or that humid process-gas atmosphere is introduced into the process chamber (12) or the humidity is introduced into the process chamber by pyrolysis, whereby especially the process gas transporting the humidity is introduced into the process chamber (12) at a temperature Tₚ with Tₚ ≥ 100°C, which corresponds preferably to that or approximately to that in the inlet region of the process chamber.

5. Procedure according to at least one of the preceding claims,
**characterized in**
**that** before feeding the semiconductor element through the process chamber, a dopant source is applied to its upper surface, whereby especially such a dopant source is used which contains phosphorus or boron.

6. Procedure according to at least one of the preceding claims,
**characterized in**
**that** one or several process gases is or are passed through a liquid such as water to absorb moisture and is or are then passed to the process chamber (12).

7. Procedure according to at least one of the preceding claims,
**characterized in**
**that** the semiconductor elements (14, 16, 18), as silicon semiconductor elements, which are used for converting light into electrical energy, are fed through the process chamber (12), which is open to the atmosphere at the inlet and/or outlet side, whereby the atmosphere in the process chamber is adjusted and/or the humidity containing process gas is introduced such that a condensate precipitate onto the semiconductor element (14, 16, 18) is avoided.

8. Procedure according to at least one of the preceding claims,
**characterized in**
**that** at least from the inlet side humidity is specifically fed to the process chamber (12) and/or that desired pressure ratios are set in the process chamber (12) for specific adjustment of the humidity in areas of the process chamber (12) and/or that the process chamber (12) to adjust the humidity features several process gas inlet and/or exhaust points (44, 48, 50, 52) and/or that humidity containing process gas is fed into the process chamber in its outlet side end region or outlet side half.

9. Procedure according to at least one of the preceding claims,
**characterized in**
**that** a process chamber (12) is used to adjust the humidity, whose cross-section varies in the feed direction of the semiconductor elements (14, 16, 18), and/or that process gas leading humidity into the process chamber (12) is fed to and/or exhausted from the process chamber over width of the process chamber extending transversally relative to the transport direction of the semiconductor elements (14, 16, 18), whereby possibly the process gas is fed to the process chamber (12) evenly distributed over the width and/or that process gas is exhausted evenly distributed over the width of the process chamber (12).

10. Procedure according to at least one of the preceding claims,
**characterized in**
**that** oxygenic process gas is fed to the process chamber (12).

11. Procedure according to at least one of the preceding claims,
**characterized in**
**that** a channel region is disposed before or after an inlet and/or outlet region of the process chamber (12).

12. Procedure according to at least one of the preceding claims,
**characterized in**
**that** the process chamber (12), respectively its atmosphere is decoupled under fluidic aspects from the atmosphere outside the process chamber (12).

13. Procedure according to at least one of the preceding claims,
**characterized in**
**that** process gas is introduced into the process chamber (12) by means of porous ceramic plates and/or ceramic pipes.

14. Procedure according to at least one of the preceding claims,
**characterized in**
**that** the heat treatment of the semiconductor elements (14, 16, 18) is performed at the temperature T, with 800°C ≤ T ≤ 1100°C, whereby especially during the heat treatment volatile components, especially phosphorus compounds as volatile components are driven from the semiconductor elements (14, 16, 18).

15. Procedure according to at least one of the preceding claims,
**characterized in**
**that** during the heat treatment, a diffusion profile, especially a phosphorus diffusion profile, is produced in the semiconductor elements (14, 16, 18).

## Revendications

1. Procédé destiné à augmenter la stabilité mécanique à long terme de moyens de transport (20, 22, 24, 26, 28, 30) au moyen desquels sont transportés des composants semi-conducteurs (14, 16, 18) à travers un espace de traitement (12) afin d'y subir un traitement thermique en continu,
**caractérisé en ce**
**qu'**en tant que moyens de transport (20, 22, 24, 26, 28, 30) sont utilisés des matériaux constitués de matériaux céramiques qui, dans l'espace de traitement (12) ouvert vers l'atmosphère extérieure, sont exposés de façon ciblée à une atmosphère humide contenant de la vapeur d'eau, sachant que dans l'espace de traitement (12), le traitement thermique est effectué sous une température T telle que T ≥ 500°C,.

2. Procédé selon la revendication 1,
**caractérisé en ce**
**que** les composants semi-conducteurs (14, 16, 18) sont transportés à travers un four continu (10) par un système de transport céramique à cordons de tirage ou par un système de transport céramique à longerons mobiles ou par des galets transporteurs céramiques, les galets transporteurs étant de préférence entraînés depuis l'extérieur du four continu (10).

3. Procédé selon la revendication 1 ou 2,
**caractérisé en ce**
**que** pour ajuster l'atmosphère humide, de l'humidité ou des gaz de traitement chargés d'humidité est/sont introduit(s) dans l'espace de traitement (12), sachant qu'en particulier l'humidité est contrôlée ou régulée dans l'espace de traitement (12).

4. Procédé selon au moins une des revendications précédentes,
**caractérisé en ce**
**que** l'humidité est introduite dans l'espace de traitement (12) au moyen d'un gaz de traitement tel que O₂, N₂, air comprimé et/ou d'un gaz rare tel que l'argon, ou qu'une atmosphère de gaz de traitement humide est introduite dans l'espace de traitement (12) ou que l'humidité est introduite par pyrolyse dans l'espace de traitement, sachant qu'en particulier le gaz de traitement chargé d'humidité est introduit dans l'espace de traitement (12) sous une température Tₚ telle que Tₚ ≥ 100 °C, qui de préférence correspond à celle ou à approximativement à celle qui règne dans la zone d'introduction dans l'espace de traitement.

5. Procédé selon au moins une des revendications précédentes,
**caractérisé en ce**
**qu'**avant le transport du composant semi-conducteur à travers l'espace de traitement, une source de substance dopante est placée sur la surface dudit composant, sachant que la source de dopage est en particulier une source contenant du phosphore ou du bore.

6. Procédé selon au moins une des revendications précédentes,
**caractérisé en ce**
**qu'**un ou plusieurs gaz de traitement est/sont guidé(s) par un liquide tel que de l'eau afin d'absorber de l'humidité, puis introduit(s) dans l'espace de traitement (12).

7. Procédé selon au moins une des revendications précédentes,
**caractérisé en ce**
**que** les composants semi-conducteurs (14, 16, 18) tels que des composants semi-conducteurs au silicium, qui sont utilisés pour convertir la lumière en énergie électrique, sont transportés à travers l'espace de traitement (12) qui est ouvert à l'atmosphère côté entrée et/ou sortie, sachant que l'atmosphère dans l'espace de traitement (12) est ajustée et/ou que le gaz de traitement chargé d'humidité est introduit de manière telle qu'un dépôt de condensat sur le composant semi-conducteur (14, 16, 18) est évité.

8. Procédé selon au moins une des revendications précédentes,
**caractérisé en ce**
**que** dans l'espace de traitement (12) est introduite de l'humidité de façon ciblée au moins côté entrée, et/ou que pour un ajustement ciblé de l'humidité dans des zones de l'espace de traitement (12), des rapports de pression souhaités sont établis dans l'espace de traitement (12), et/ou que pour ajuster l'humidité, l'espace de traitement (12) présente plusieurs points d'introduction et/ou d'aspiration de gaz de traitement (44, 48, 50, 52), et/ou que le gaz de traitement chargé d'humidité est amené dans l'espace de traitement à l'extrémité côté sortie et/ou dans la moitié côté sortie dudit espace de traitement.

9. Procédé selon au moins une des revendications précédentes,
**caractérisé en ce**
**que** pour ajuster l'humidité est utilisé un espace de traitement (12) dont la section transversale varie dans le sens de transport des composants semi-conducteurs (14, 16, 18), et/ou que le gaz de traitement introduisant l'humidité dans l'espace de traitement (12) est amené et/ou aspiré dans l'espace de traitement sur la largeur de l'espace de traitement, laquelle s'étend transversalement au sens de transport des composants semi-conducteurs (14, 16, 18), sachant que le cas échéant, le gaz de traitement est amené dans l'espace de traitement (12) en étant réparti uniformément sur la largeur, et/ou que du gaz de traitement est aspiré en étant réparti uniformément sur la largeur de l'espace de traitement (12).

10. Procédé selon au moins une des revendications précédentes,
**caractérisé en ce**
**que** du gaz de traitement contenant de l'oxygène est amené dans l'espace de traitement (12).

11. Procédé selon au moins une des revendications précédentes,
**caractérisé en ce**
**qu'**une zone faisant office de sas est placée en amont ou en aval de la zone d'entrée et/ou de sortie de l'espace de traitement (12).

12. Procédé selon au moins une des revendications précédentes,
**caractérisé en ce**
**que** l'espace de traitement (12) et/ou son atmosphère est/sont découplé(e)(s) de l'atmosphère à l'extérieur de l'espace de traitement (12) par des mesures relevant de la technique des fluides.

13. Procédé selon au moins une des revendications précédentes,
**caractérisé en ce**
**que** le gaz de traitement est introduit dans l'espace de traitement (12) par l'intermédiaire de carreaux et/ou de tubes céramiques poreux.

14. Procédé selon au moins une des revendications précédentes,
**caractérisé en ce**
**que** le traitement thermique des composants semi-conducteurs (14, 16, 18) est effectué sous une température T telle que 800 °C ≤ T ≤ 1100 °C, sachant qu'en particulier au cours du traitement thermique, des constituants volatiles, notamment des composés phosphorés en tant que constituants volatiles, sont expulsés des composants semi-conducteurs (14, 16, 18).

15. Procédé selon au moins une des revendications précédentes,
**caractérisé en ce**
**que** pendant le traitement thermique est établi dans les composants semi-conducteurs (14, 16, 18) un profil de diffusion, en particulier un profil de diffusion du phosphore.
